## Europäisches Patentamt
## European Patent Office
## Office européen des brevets

(19)

(11) Veröffentlichungsnummer: **0 220 646 B1**

(12) **EUROPÄISCHE PATENTSCHRIFT**

(45) Veröffentlichungstag der Patentschrift: **14.08.91**

(51) Int. Cl.⁵: **B26D 1/11, //B26D1/60**

(21) Anmeldenummer: **86114512.6**

(22) Anmeldetag: **20.10.86**

(54) **Trennvorrichtung für Platten.**

(30) Priorität: **26.10.85 DE 3538117**

(43) Veröffentlichungstag der Anmeldung:
**06.05.87 Patentblatt 87/19**

(45) Bekanntmachung des Hinweises auf die
Patenterteilung:
**14.08.91 Patentblatt 91/33**

(84) Benannte Vertragsstaaten:
**AT BE CH DE FR GB IT LI NL SE**

(56) Entgegenhaltungen:
**EP-A- 0 040 842        EP-A- 0 040 843**
**EP-A- 0 041 642        EP-A- 0 157 261**
**DE-A- 2 418 213        DE-A- 2 816 419**
**DE-U- 1 922 327        US-A- 3 566 728**
**US-A- 4 214 936**

(73) Patentinhaber: **HOECHST AKTIENGESELL-
SCHAFT**
**Postfach 80 03 20**
**W-6230 Frankfurt am Main 80(DE)**

(72) Erfinder: **Stork, Martin**
**Hauffstrasse 9**
**W-6052 Mühlheim am Main(DE)**

## Beschreibung

Die Erfindung betrifft eine Trennvorrichtung für Platten, die voneinander beabstandet sind und auf die zumindest ein zusammenhängendes Band aufkaschiert ist, mit einem Aufbau, der in Förderrichtung des Bandes hin- und herverfahrbar ist, sich über die Breite des Bandes hinaus erstreckt und durch den das Band mit den Platten hindurchgeführt ist, mit zu beiden Seiten des Bandes angeordneten vertikalen Stützen des Aufbaus, an denen ein quer zum und über dem Band verlaufendes Antriebselement für eine Querschneideinrichtung mit zwei zueinander parallelen Messern befestigt ist.

Aus dem Dokument DE-A - 24 18 213 ist eine derartige Querschneideinrichtung zum Trennen eines fortlaufend zugeführten Stranges aus mindestens einer Kaschierbahn aus Dachpappe mit daran mit Abstand befestigten Styroporplatten in einzelne kaschierte Abschnitte bekannt. Zum bündigen Querschneiden einer ersten, am Schnittanfang festlegbaren Kaschierbahn ist ein erstes, an einer Plattenstirnfläche in Längsrichtung entlang geführtes, synchron mit dem Strang mitlaufendes Querschneidmesser vorgesehen, das in Strangförderrichtung axial nachgiebig gelagert ist und an seinem, gegen die Plattenstirnfläche zur Anlage kommenden freien Ende, zweiseitig, in bezug auf die Plattenstirnfläche von dieser weggeneigt verlaufende Schenkel aufweist. Die für jedes Querschneidmesser vorgesehene Fassung in einer Halterung ist gegen eine Federkraft axial verschiebbar gelagert, wobei die axialen Verschiebebewegungen der Fassungen parallel zur Förderrichtung des Stranges liegen.

Aus den europäischen Patentanmeldungen EP-A-0 040 842, EP-A-0 040 843 und EP-A-0 041 642 sind Laminierverfahren bekannt, bei denen ein Substrat bzw. ein Schichtträger beidseitig unter Druckanwendung mit einem Trockenresist laminiert wird. Der Trockenresist wird für die jeweilige zu laminierende Seite des Schichtträgers, beispielsweise eine Leiterplatte, von einer Vorratsrolle abgezogen und einem Paar von Laminierwalzen zugeführt, durch deren Spalt die beiden Trockenresistfilme und der dazwischen befindliche Schichtträger hindurchlaufen. Vor dem Laminieren wird auf die Oberfläche des Schichtträgers bzw. der Leiterplatte eine dünne Flüssigkeitsschicht aufgebracht, die eine Zwischenschicht zwischen der Oberfläche der Leiterplatte und dem jeweiligen Trockenresistfilm während des Laminiervorgangs bildet. Diese dünne Flüssigkeitsschicht wird von der Oberfläche der Leiterplatte durch Absorption in den Trockenresistfilm während des Laminierens entfernt. Nach dem Laminieren ist der Schichtträger beidseitig mit einer Trockenresistschicht ausgestattet, so daß beide Seiten des Schichtträgers, im allgemeinen eine Leiter- oder Druckplatte, belichtet und entwickelt werden können.

Die US-A-4,214,936 betrifft ein Laminierverfahren, bei dem horizontal transportierte Platten, die kontinuierlich vorwärtsbewegt und kontaktbeheizt werden, beidseitig laminiert werden. Sobald ein Sensor die Hinterkante der vorgeheizten Platte kurz vor ihrem Eintritt in den Spalt zwischen den Laminierwalzen feststellt, werden diese erst nach einer gewissen Verzögerungszeit gestoppt, wodurch es ermöglicht wird, daß die Hinterkante der Platte den Laminierspalt passiert. Sobald die Vorderkante der nachfolgenden Platte festgestellt wird, beginnen die Laminierwalzen von neuem zu rotieren und die in den Spalt eintretende Platte wird laminiert. Dieser Vorgang wiederholt sich für jede neue Platte und es wird dadurch ein gleichbleibender Abstand zwischen den einzelnen laminierten Platten nach dem Spalt erhalten. Dabei entsteht ein zusammenhängendes Band aus zwei Trockenresistschichten, zwischen denen jeweils im gleichen Abstand die Platten eingeschlossen sind. Die Verbindungslänge der Resistschichten zwischen zwei Platten kann beispielsweise bis zu 18 mm betragen. Von Nachteil ist dabei, daß das Trennen der Platten voneinander zwei Schneidvorgänge verlangt, nämlich zunächst das Verbindungsstück aus dem Trockenresist entlang der Hinterkante der vorderen Platte und anschließend entlang der Vorderkante der hinteren Platte abzuschneiden. Häufig werden sogar drei Schnittvorgänge erforderlich, da beim ersten Schnitt zunächst nur das Verbindungsstück zwischen zwei Platten durchschnitten wird und erst anschließend die einzelne Platte in der Weise verarbeitet wird, daß die über die Vorder- bzw. Hinterkante über-stehende Trockenresistschicht erst beim Konfektionieren der einzelnen Platte kantengleich abgeschnitten wird.

Aufgabe der Erfindung ist es, eine Trennvorrichtung der eingangs beschriebenen Art so zu verbessern, daß in einem einzigen Schneidvorgang aufeinander folgende, zusammenhängende Platten voneinander getrennt und zugleich das die Platten miteinander verbindende Trockenresistlaminat kantengenau entlang der Hinter- und Vorderkante aufeinander folgender Platten abgeschnitten wird.

Diese Aufgabe wird erfindungsgemäß dadurch gelöst, daß die vertikalen Stützen auf einem plattenförmigen Wagen des Aufbaus angeordnet sind, der auf linearen Kugelführungen aufsitzt und motorisch entlang den parallel zum Band verlaufenden Kugelführungen verfahrbar ist, daß das Antriebselement ein pneumatisch betätigter, kolbenstangenloser Antriebszylinder mit einem angetriebenen aufrollbaren Band für eine verfahrbare Halterung ist, an der die Querschneideinrichtung befestigt ist, deren zwei Messerhalter auf Führungsteilen befestigt sind, die Kugelbuchsen aufweisen, welche auf Führungsachsen in Bewegungsrichtung des Bandes laufen, so daß die Messerhalter mit den Messern auseinander- und zusammenfahrbar sind, so daß sie sich während des Schneidvorgangs an die Hinter- und Vorderkante benachbarter Platten anlegen und das aus einer Trockenresistschicht bestehende Band entlang dieser Hinter- und Vorderkante gleichzeitig durchschneiden.

In weiterer Ausgestaltung der Erfindung befindet sich im Bereich der Querschneideinrichtung ein erster Sensor, der beim Erfassen der Vorderkante jeder Platte Signale an Niederhalter für Niederhalterleisten, an den Antriebszylinder der Querschneideinrichtung und an den Motor für die Längsbewegung der Trennvorrichtung liefert.

Die weitere Ausbildung der Erfindung ergibt sich aus den Merkmalen der Patentansprüche 3 bis 10.

Mit der Erfindung werden die Vorteile erzielt, daß die Platten schon während des Trennvorgangs konfektioniert werden, d.h. während eines Doppelschnittes das Trockenresistlaminat zwischen den Platten entlang der Vorder- und Hinterkante kantengenau geschnitten wird und daß unterschiedliche Abstände zwischen aufeinanderfolgenden Platten bei dem Doppelschnitt jeweils durch das Auseinanderfahren der Messerhalter bis zum Anschlag der Messer an den Plattenkanten automatisch berücksichtigt werden können.

Die Erfindung wird im folgenden anhand des zeichnerisch dargestellten Ausführungsbeispiels näher erläutert.

Es zeigen:

Fig. 1    eine schematische perspektivische Ansicht der Trennvorrichtung nach der Erfindung,

Fig. 2    eine geschnittene Unteransicht der Querschneideinrichtung nach der Erfindung,

Fig. 3    eine Seitenansicht eines Antriebszylinders für die Halterung der Querschneideinrichtung,

Fig. 4    eine Vorderansicht gemäß Fig. 3, und

Fig. 5    als Detail der Querschneideinrichtung eine Ansicht eines Messerhalters und eines Messers.

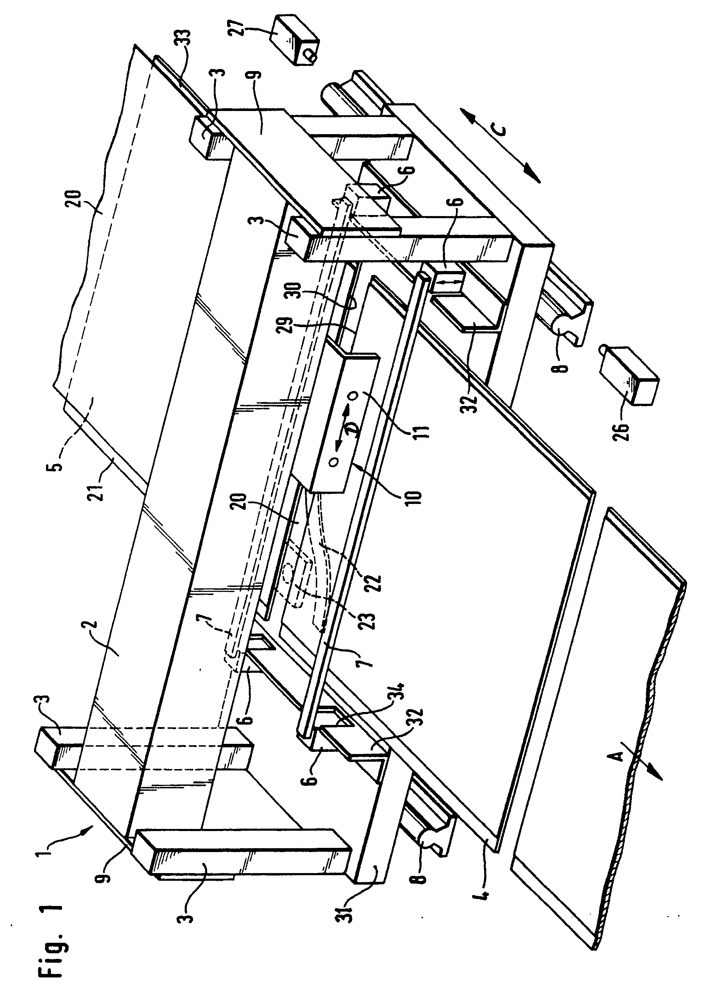

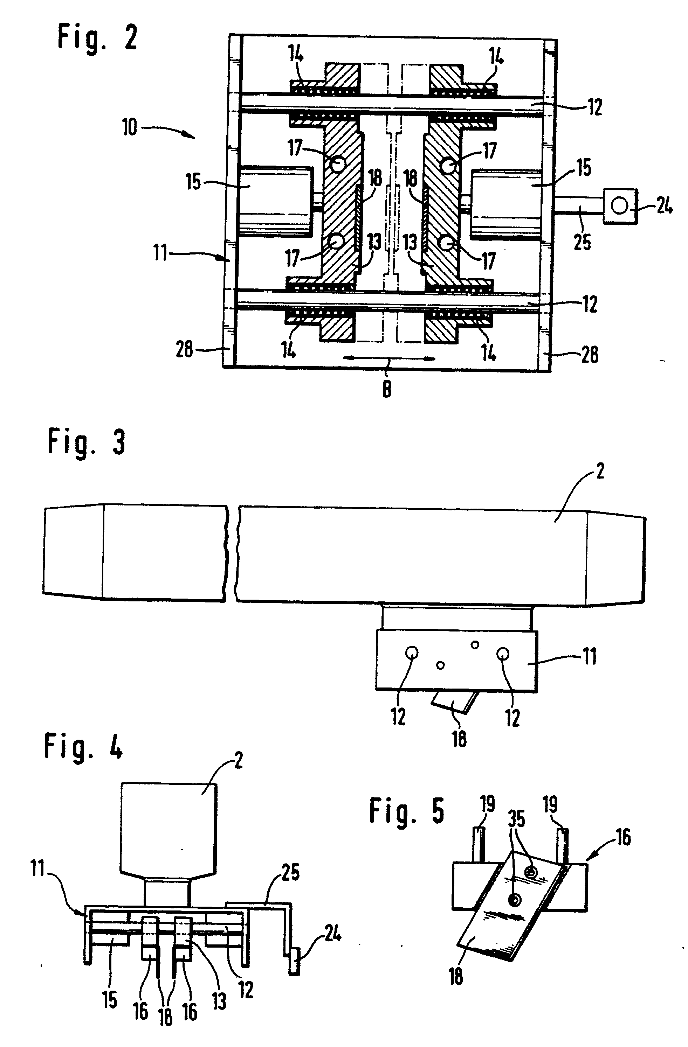

Die in Fig. 1 dargestellte Trennvorrichtung 1 umfaßt einen Wagen 31, auf dem eine Zylinderhalterung aus Stützen 3 für einen Antriebszylinder 2 befestigt ist, der sich über die Breite eines Bandes 20 hinaus erstreckt. Der Antriebszylinder 2 ist mit einer Halterung 11 für eine Querschneideinrichtung 10 (vgl. Fig. 2) verbunden, die in der Halterung 11 befestigt ist. Das Band 20 besteht aus einer zusammenhängenden Trockenresistschicht bzw. einem Trockenschichtlaminat, das auf Platten 4 und 5 in einer nicht gezeigten Laminiervorrichtung unter Anwendung von Druck und Hitze auflaminiert ist. Üblicherweise werden sowohl die Ober- als auch die Unterseiten der Platten 4 und 5 jeweils mit einem zusammenhängenden Band einer Trockenresistschicht bzw. Fotoresistschicht laminiert. Die Trennvorrichtung 1 erstreckt sich über die Breite des Bandes 20 hinaus, das nicht die volle Breite der Platten 4 und 5 abdeckt, sondern einen breiteren Rand 21 und einen schmaleren Rand 33 der Platten freiläßt.

Die Trennvorrichtung 1 ist in Längsrichtung des Bandes 20, das sich in Laufrichtung A bewegt, hin- und herverfahrbar, wie dies der Doppelpfeil C andeutet. Die Halterung 11 mit der daran befestigten Querschneideinrichtung 10 ist in Querrichtung des Bandes 20 hin-und herverfahrbar, wie dies der Doppelpfeil D andeutet und wie im einzelnen noch näher beschrieben werden wird.

Die Stirnflächen des Antriebszylinders 2 sind mit Befestigungsplatten 9,9 verbunden, die auf den Stützen 3 der Zylinderhalterung befestigt sind. Bei dem Antriebszylinder 2 handelt es sich beispielsweise um einen bekannten pneumatischen kolbenstangenlosen Zylinder mit beidseitig einstellbarer Dämpfung seines Bandantriebs. Die Hubgeschwindigkeit des Antriebszylinders soll 1,5 m/sec nicht übersteigen, da ansonsten mit zunehmender Geschwindigkeit der Verschleiß stark ansteigt. Das anzutreibende geführte Teil, im vorliegenden Fall die Halterung 11 mit der Querschneideinrichtung 10, wird von dem nicht gezeigten Stahlband des Antriebszylinders 2 gezogen. Beim Anschluß des Antriebszylinders 2 und bei der Einstellung der Dämpfung wird die Gegenläufigkeit des Kolbens und des Schlittens beachtet. Die Dämpfung ist so ausgelegt, daß bei der Positionierung der angetriebenen und geführten Halterung 11 eine eventuelle Überfahrstrecke berücksichtigt wird, die jeweils von der Hubgeschwindigkeit und der Schaltzeit des Antriebszylinders 2 abhängt. Bei einem bekannten Antriebszylinder 2 ergeben sich beispielsweise bei einer Hubgeschwindigkeit von 500 mm/sec mit einer Schaltzeit von 20 msec 10 mm Überfahrstrecke. Streuungen von ± 1 msec in der Schaltzeit verringern die Wiederholgenauigkeit um ± 0,5 mm. Da Streuungen in der Schaltzeit kaum vermeidbar sind, wird der Antriebszylinder 2 so betrieben, daß kurz vor seiner Halteposition die Dämpfung einsetzt und mit einer sogenannten Schleichgeschwindigkeit das Stahlband des Antriebszylinders 2 in seine Halteposition bewegt wird.

Der Wagen 31 der Trennvorrichtung 1 sitzt auf linearen Kugelführungen 8,8 zu beiden Seiten parallel zur Laufrichtung A des Bandes auf und wird durch einen nicht gezeigten Motor hin- und herverfahren.

In Fig. 1 sind nahe der vorderen Endfläche der rechten Kugelführung 8 ein erster Endschalter 26 und nahe der hinteren Endfläche der Kugelführung ein zweiter Endschalter 27 dargestellt. Der erste Endschalter 26 wird von der Stirnfläche des Wagens 31 betätigt, wenn die Trennvorrichtung 1 aus ihrer Ausgangsstellung in Richtung der Laufrichtung A des Bandes 20 verfahren wird. Dieser Endschalter 26 löst Niederhalter 6,6 aus, die die Niederhalterleisten 7,7 von der Deckfläche des Wagens abheben. Zugleich wird auch die Drehrichtung des Motors, der die Trennvorrichtung 1 antreibt, umgeschaltet und die Trennvorrichtung entgegen der Laufrichtung A verfahren, solange bis die Trennvorrichtung 1 ihre Ausgangslage erreicht hat und den zweiten Endschalter 27 betätigt, der den Motor stillsetzt und einen ersten Sensor 23, bei dem es sich hier beispielsweise um ein optoelektronisches Element aus Fotodiode, Fototransistor, Fotowiderstand in Kombination mit einer Optik und einer Lichtquelle handelt, freigibt, so daß der Sensor 23 die Hinterkante 29 der Platte 4 bzw. die Vorderkante 30 der Platte 5 registrieren kann. Der Sensor 23 ist in Fig. 1 gestrichelt im Bereich der Querschneideinrichtung nahe dem Rand 21 des Bandes 20 angedeutet. Die Halterung 11 der Querschneideinrichtung bewegt sich in Fig. 1 nach erfolgtem Doppelschnitt entlang der Hinterkante 29 und der Vorderkante 30 in Richtung auf den rechten Rand 33 der Platten 4 und 5 zu. Bei dem Doppelschnitt entsteht der gestrichelt angedeutete Abfallstreifen 22 des Trockenresistlaminats.

Sobald der erste Sensor 23 die Vorderkante 30 der Platte 5 erfaßt, liefert er Signale an die Niederhalter 6,6 der vorderen und der hinteren Niederhalterleiste 7,7, an den Antriebszylinder 2 der Querschneideinrichtung und an den Motor für die Längsbewegung der Trennvorrichtung 1. Jede der Niederhalterleisten 7,7 erstreckt sich über die Breite des Bandes 20 vor und hinter der Querschneideinrichtung, gesehen in Laufrichtung A des Bandes 20. Die pneumatisch betätigten Niederhalter 6,6 sind an den Innenseiten von Winkelanschlägen 32,32 angeordnet, die parallel zu den beiden Längsseiten des Bandes 20 auf dem Wagen 31 angebracht sind. Jede der beiden Niederhalterleisten 7,7 ist an ihren Enden mit den pneumatisch betätigten Niederhaltern 6,6 verbunden, die beim Empfang von Signalen von dem ersten Sensor 23 die Niederhalterleisten 7,7 an das Band 20 bzw. an die darunter befindliche Platte und diese an die Deckfläche des Wagens 31 anpressen. Wenn der Sensor 23 kein Signal liefert, heben die Niederhalter 6,6 die Niederhalterleisten 7,7 von dem Band 20 bzw. der Platte ab. Damit die Niederhalterleisten 7,7 auf- und abbewegt werden können, befinden sich Schlitze 34 in den vertikalen Schenkeln der Winkelanschläge 32,32. Einer dieser Schlitze 34 ist in Fig. 1 gezeigt.

Die Halterung 11 der Querschneideinrichtung 10 ist U-förmig ausgebildet und weist zwei Schenkel 28,28 auf, in denen zwei Führungsachsen 12,12 mit ihren Enden gelagert sind. Die Querschneideinrichtung 10 besteht aus zwei Messerhaltern 16,16 mit zueinander parallelen Messern 18,18. Die Messerhalter 16,16 sind auseinander- und zusammenfahrbar, und während der Querbewegung der Querschneideinrichtung 10 über das Band 20 führen die zueinander parallelen Messer 18,18 entlang der Hinter- und der Vorderkante 29 bzw. 30 der benachbarten Platten 4 und 5 gleichzeitig einen Doppelschnitt aus und durchschneiden das Trockenresistlaminat, das die beiden Platten verbindet. Jeder Messerhalter 16 ist mit einem zugehörigen Führungsteil 13 verbunden, das zu beiden Seiten mit Kugelbuchsen 14,14 ausgerüstet ist. Die Kugelbuchsen 14,14 laufen auf den beiden Führungsachsen 12,12. Jedes Führungsteil 13 ist in seiner Mitte mit einem Führungszylinder 15 verbunden, der pneumatisch betätigt wird und das Führungsteil 13 mit seinen Kugelbuchsen 14,14 entlang den Führungsachsen 12,12 hin- und herverschiebt. In Fig. 2 ist die auseinandergefahrene Stellung der beiden Führungsteile 13 mit festen Linien eingezeichnet, während die zusammengefahrene Stellung der beiden Führungsteile gestrichelt dargestellt ist.

Der Doppelpfeil B deutet das Auseinander- bzw. Zusammenfahren der beiden Führungsteile 13,13 an. An dem einen Schenkel 28, in Fig. 2 am rechten Schenkel, ist ein zweiter Sensor 24 mittels eines Winkelarms 25 befestigt. Jedes Führungsteil 13 weist zwei Löcher 17,17 auf, die symmetrisch zur Mitte des einzelnen Führungsteils liegen.

Wie aus Fig. 5 ersichtlich ist, ist jeder Messerhalter 16 mit zwei Steckbolzen 19,19 ausgerüstet, die in die Löcher 17,17 des zugehörigen Führungsteils 13 eingesteckt werden. Die Steckbolzen 19,19 werden durch nicht gezeigte Madenschrauben in ihrer eingesteckten Lage in den Löchern 17,17 fixiert. Das Messer 18 ist schräg in einer Ausnehmung des Messerhalters 16 mit zwei versenkten Imbus-Schrauben 35 befestigt. Aufgrund dieser Bauweise ist das Auswechseln der Messer 18 sehr einfach zu bewerkstelligen, da nur die Steckverbindung zwischen dem Messerhalter 16 und dem Führungsteil 13 durch Herausziehen des Messerhalters 16 gelöst werden muß und anschließend nach dem Herausschrauben der beiden Imbus-Schrauben 35 das Messer 18 gewechselt werden kann.

Die Figuren 3 und 4 zeigen eine Seitenansicht und eine Vorderansicht des Antriebszylinders 2 und der Halterung 11 mit der Querschneideinrichtung 10. In Fig. 4 ist der an dem einen U-Schenkel 28 angebrachte Winkelarm 25 mit dem zweiten Sensor 24 zum Erfassen einer Seitenkante der Platte 4 bzw. 5 dargestellt. Der zweite Sensor 24 liefert Signale an den Antriebszylinder 2 und die Führungszylinder 15,15 der Führungsteile 13,13, sobald die Seitenkante der Platte von dem Sensor 24 erfaßt wird. In Fig. 4 sind die Messerhalter 16 nicht vollständig zusammengefahren, und die Messer 18 sind voneinander beabstandet.

Die Trennvorrichtung 1 arbeitet wie folgt:
Wenn eine erste Platte 4 in die Trennvorrichtung 1 einläuft, ist der erste Sensor 23 gesperrt. Sobald eine zweite Platte 5 einläuft, ist der Sensor 23 betriebsbereit und erfaßt die Vorderkante der Platte 5, wenn diese den auf den Sensor 23 gerichteten Lichtstrahl durchschneidet. Der Sensor 23 liefert Signale an die Niederhalter 6,6, die die quer zur Laufrichtung A der Platten 4 und 5 liegenden Niederhalterleisten 7,7 gegen die Platten 4 und 5 andrücken, um diese festzuhalten. Des weiteren gibt der Sensor 23 Signale an den Antriebszylinder 2, an dem die Halterung 11 mit der Querschneideinrichtung 10 befestigt ist, die aufgrund der Signale aus ihrer Ausgangsstellung langsam in Laufrichtung A vorgefahren wird. Der nicht gezeigte Motor für die Hin- und Herbewegung der Trennvorrichtung 1 in Laufrichtung A empfängt von dem Sensor 23 gleichfalls Signale und bewegt synchron mit der Plattengeschwindigkeit den Wagen 31 der Trennvorrichtung 1 entlang den Kugelführungen 8,8 in Laufrichtung A. Diese Bewegung läuft solange ab, bis der zweite Sensor 24, die eine Seitenkante der Platte 5 erfaßt, die zuvor ausgerichtet wurde. Der zweite Sensor 24 setzt den Antriebszylinder 2 still und fährt die Messerhalter 16,16 soweit auseinander, daß die Messer 18,18 an der Hinterkante 29 der Platte 4 und an der Vorderkante 30 der Platte 5 anliegen. Die Messerhalter 16,16 befinden sich bei diesem Vorgang im Bereich des linken Randes 21 des Bandes 20 in Fig. 1.

Mit einer Verzögerung von etwa 1/10 Sekunde fährt dann der Antriebszylinder 2 die Messerhalter 16,16 im Schnellgang quer über das Band 20, und es erfolgt der kantengenaue Doppelschnitt längs der Hinterkante 29 und der Vorderkante 30. Die Halterung 11 fährt nach rechts in Fig. 1 bis zu einem nicht gezeigten Anschlag, bei dessen Berührung die Führungszylinder 15,15 der Führungsteile 13,13 der Messerhalter 16,16 umgeschaltet werden, so daß die Messerhalter 16,16 zusammenfahren. Im Schnellgang wird dann die Querschneideinrichtung 10 in ihre Ausgangsstellung am rechten Rand 21 des Bandes 20 zurückgefahren.
Der Wagen 31 der Trennvorrichtung 1 wird bis zu dem ersten Endschalter 26 vorgefahren, der betätigt wird und die Niederhalter 6,6 löst, welche die Niederhalterleisten 7,7 von den Platten 4 und 5 abheben. Zugleich wird der Motor umgepolt und der Wagen 31 im Schnellgang in seine Ausgangsstellung zurückgefahren. Dabei ist der erste Sensor 23 gesperrt, da er die Platte 5 überfährt und dabei kein Signal abgeben darf. In der Ausgangslage des Wagens 31 wird der zweite Endschalter 27 betätigt, der den Motor stillsetzt und den ersten Sensor 23 wieder betriebsbereit macht, indem er ihn freigibt. Die Trennvorrichtung 1 ist dann für einen neuen Schnittvorgang bereit.

## Patentansprüche

1.  Trennvorrichtung (1) für Platten (4, 5) die voneinander beabstandet sind und auf die zumindest ein zusammenhängendes Band (20) aufkaschiert ist, mit einem Aufbau, (3, 31) der in Förderrichtung A des Bandes hin- und hervverfahrbar ist, sich über die Breite des Bandes hinaus erstreckt und durch den das Band mit den Platten hindurchgeführt ist, mit zu beiden Seiten des Bandes angeordneten vertikalen Stützen (3) des Aufbaus, an denen ein quer zum und über dem Band verlaufendes Antriebselement (2) für eine Querschneideinrichtung (10) mit zwei zueinander parallelen Messern (18, 18) befestigt ist, dadurch gekennzeichnet, daß die vertikalen Stützen (3) auf einem plattenförmigen Wagen (31) des Aufbaus angeordnet sind, der auf linearen Kugelführungen (8, 8) aufsitzt und motorisch entlang den parallel zum Band verlaufenden Kugelführungen verfahrbar ist, daß das Antriebselement ein pneumatisch betätigter, kolbenstangenloser Antriebszylinder (2) mit einem angetriebenen aufrollbaren Band für eine verfahrbare Halterung (11) ist, an der die Querschneideinrichtung (10) befestigt ist, deren zwei Messerhalter (16, 16) auf Führungsteilen (13, 13) befestigt sind, die Kugelbuchsen (14, 14) aufweisen, welche auf Führungsachsen (12, 12) in Bewegungsrichtung A des Bandes (20) laufen, so daß die Messerhalter mit den Messern (18, 18) auseinander- und zusammenfahrbar sind, so daß sie sich während des Schneidvorgangs an die Hinter- und Vorderkante (29 bzw. 30) benachbarter Platten (4, 5) anlegen und das aus einer Trockenresistschicht bestehende Band (20) entlang dieser Hinter- und Vorderkante gleichzeitig quer durchschneiden.

2.  Trennvorrichtung nach Anspruch 1, dadurch gekennzeichnet, daß sich im Bereich der Querschneideinrichtung (10) ein erster Sensor (23) befindet, der beim Erfassen der Vorderkante (30) jeder Platte (4,5) Signale an Niederhalter (6,6) für Niederhalterleisten (7,7), an den Antriebszylinder (2) der Querschneideinrichtung (10) und an den Motor für die Längsbewegung der Trennvorrichtung (1) liefert.

3. Trennvorrichtung nach Anspruch 1, dadurch gekennzeichnet, daß die U-förmige Halterung (11) für die Querschneideinrichtung (10) als angetriebenes und gerührtes Teil an dem Antriebszylinder (2) befestigt ist, der ein pneumatischer kolbenstangenloser Zylinder mit beidseitig einstellbarer Dämpfung seines Bandantriebs ist.

4. Trennvorrichtung nach Anspruch 3, dadurch gekennzeichnet, daß die Stirnflächen des Antriebszylinders (2) an Befestigungsplatten (9,9) angebracht sind, die über die Stützen (3) der Zylinderhalterung mit dem Wagen (31) der Trennvorrichtung (1) verbunden sind.

5. Trennvorrichtung nach Anspruch 2, dadurch gekennzeichnet, daß sich je eine Niederhalterleiste (7,7) über die Breite des Bandes (20) vor und hinter der Querschneideinrichtung (10), gesehen in Laufrichtung A des Bandes (20), erstreckt.

6. Trennvorrichtung nach Anspruch 5, dadurch gekennzeichnet, daß jede der beiden Niederhalterleisten (7,7) an ihren Enden mit den pneumatisch betätigten Niederhaltern (6,6) verbunden ist, die die Niederhalterleisten (7,7) an das Band (20) und dieses an die Deckfläche des Wagens (31) anpressen bzw. davon abheben und daß die Niederhalter (6,6) an den Innenseiten von Winkelanschlägen (32,32) angeordnet sind, die parallel zu beiden Längsseiten des Bandes (20) auf dem Wagen (31) angebracht sind.

7. Trennvorrichtung nach Anspruch 1, dadurch gekennzeichnet, daß jeder Messerhalter (16) zwei Steckbolzen (19, 19) aufweist, mit denen er in Löcher (17, 17) des zugehörigen Führungsteils (13) einsteckbar ist, daß das einzelne Führungsteil (13) zu beiden Seiten mit den Kugelbuchsen (14, 14) ausgerüstet ist, daß die Führungsachsen (12, 12) in den U-Schenkeln (28, 28) der Halterung (11) gelagert sind und daß jedes Führungsteil (13) in seiner Mitte mit einem Führungszylinder (15) verbunden ist, der das Führungsteil (13) entlang den Führungsachsen (12, 12) hin- und herverschiebt.

8. Trennvorrichtung nach Anspruch 7, dadurch gekennzeichnet, daß an dem einen U-Schenkel (28) ein Winkelarm (25) mit einem zweiten Sensor (24) zum Erfassen einer Seitenkante der Platte (4;5) angeordnet ist, und daß der Sensor (24) Signale an den Antriebszylinder (2) und die Führungszylinder (15,15) liefert.

9. Trennvorrichtung nach Anspruch, dadurch gekennzeichnet, daß nahe der vorderen Endfläche der einen Kugelführung (8) ein erster Endschalter (26) angeordnet ist, der von der Stirnfläche des Wagens (31) betätigt die Niederhalter (6,6) löst, die die Niederhalterleisten (7,7) von der Deckfläche des Wagens (31) abheben.

10. Trennvorrichtung nach Anspruch, dadurch gekennzeichnet, daß sich nahe der hinteren Endfläche der einen Kugelführung (8) ein zweiter Endschalter (27) befindet, den die Trennvorrichtung (1) in ihrer Ausgangslage betätigt, um den ihre Hin-und Herbewegung antreibenden Motor stillzusetzen und den ersten Sensor (23) freizugeben.

## Claims

1. A separating device (1) for plates (4, 5), which are arranged at a distance from one another and onto which at least one continuous web (20) is laminated, comprising a superstructure (3, 31), which can be moved to and fro in the transport direction (A) of the web and which extends beyond the width of the web, and through which the web, together with the plates, is guided, further comprising vertical pillars (3) supporting the superstructure, which are arranged at the two sides of the web and to which a drive element (2) for a cross-cutting means (10) with two knives (18, 18) in parallel alignment relative to one another is fastened, said drive element being aligned perpendicularly to the web and above the web, characterized in that the vertical supporting pillars (3) are mounted on a plate-shaped carriage (31) of the superstructure, said carriage resting on linear spherical guides (8, 8) and being movable by means of a motor along these spherical guides which are arranged in parallel alignment with the web (20) on both sides of the latter, that the drive element is a pneumatically actuated drive cylinder (2) without a piston rod, including a driven windable belt for a displaceable mounting (11) to which the cross-cutting means (10) is fastened, the two knife holders (16, 16) of which are fastened to guide elements (13, 13) equipped with spherical bushes (14, 14) running on guide pins (12, 12) in the transport direction (A) of the web (20), so that the knife holders with the knives (18, 18) are movable apart from one another and together again, so that during the cutting operation they come into contact with the trailing edge and leading edge, respectively, (29, 30) of the adjacent plates (4, 5) and simultaneously sever the web (20) comprising a dry resist layer along these trailing and leading edges in the transverse direction.

2. The separating device as claimed in claim 1, characterized in that there is located in the region of the cross-cutting means (10) a first sensor (23) which, when it detects the leading edge (30) of each plate (4, 5) supplies signals to holding-down means (6, 6) for holding-down bars (7, 7), to the drive cylinder (2) of the cross-cutting means (10) and to the motor for the longitudinal movement of the separating device (1).

3. The separating device as claimed in claim 1, characterized in that the U-shaped mounting (11) for the cross-cutting means (10) is fastened as a driven and guided part to the drive cylinder (2) which is a pneumatic cylinder without a piston rod, with its belt drive damped adjustably on both sides.

4. The separating device as claimed in claim 3, characterized in that the end faces of the drive cylinder (2) are attached to fastening plates (9, 9) which are connected to the carriage (31) of the separating device (1) via the pillars (3) of the cylinder mounting.

5. The separating device as claimed in claim 2, characterized in that a holding-down bar (7, 7) extends over the width of the web (20) in front of and behind the cross-cutting means (10), seen in the running direction A of the strip (20).

6. The separating device as claimed in claim 5, characterized in that each of the two holding-down bars (7, 7) is connected at its ends to the pneumatically actuated holding-down means (6, 6) which press the holding-down bars (7, 7) against the web (20) and the latter against the covering surface of the carriage (31) or lift them off from it, and that the holding-down means (6, 6) are arranged on the insides of angle stops (32, 32) which are attached to the carriage (31) parallel to the two longitudinal sides of the web (20).

7. The separating device as claimed in claim 1, characterized in that each knife-holder (16) has two cotter pins (19, 19), by means of which it can be inserted into holes (17, 17) provided in the associated guide part (13), that the individual guide part (13) is equipped on both sides with spherical bushes (14, 14), that the guide pins (12, 12) are mounted in the U-legs (28, 28) of the mounting (11), and that each guide part (13) is connected at its center to a guide cylinder (15) which pushes the guide part (13) to and fro along the guide pins (12, 12).

8. The separating device as claimed in claim 7, characterized in that an angle arm (25) with a second sensor (24) for detecting a side edge of the plate (4, 5) is arranged on one U-leg (28), and that the sensor (24) supplies signals to the drive cylinder (2) and to the guide cylinders (15, 15).

9. The separating device as claimed in claim 1, characterized in that a first limit switch (26) is arranged near the front end face of one spherical guide (8) and, actuated by the end face of the carriage (31), releases the holding-down means (6, 6) which lift the holding-down bars (7, 7) off from the covering surface of the carriage (31).

10. The separating device as claimed in claim 1, characterized in that there is located near the rear end face of the first spherical guide (8) a second limit switch (27) which is actuated by the separating device (1) in its initial position, in order to stop the motor causing it to move to and fro and to clear the first sensor (23).

**Revendications**

1. Dispositif de séparation (1) pour des plaques (4,5), qui sont mutuellement distantes et sur lesquelles est doublée au moins une bande continue (20), ce dispositif comprenant une structure (3,31) qui est mobile en va-et-vient dans la direction de transport (A) de la bande, qui s'étend sur et au-delà de la largeur de la bande et à travers laquelle on fait passer la bande avec les plaques, avec des montants verticaux (3) de la structure qui sont disposés des deux côtés de la bande et sur lesquels est fixé un élément d'entraînement (2), s'étendant transversalement et au-dessus de la bande, pour un dispositif de coupe transversale (10) muni de deux lames parallèles (18,18), caractérisé en ce que les montants verticaux (3) sont disposés sur un chariot en forme de plaque (31) de la structure, qui repose sur des guides à billes linéaires (8,8) et qui peut être déplacé de manière motorisée le long des guides à billes s'étendant parallèlement à la bande, en ce que l'élément d'entraînement est un vérin d'entraînement pneumatique (2), dépourvu de tige de piston et muni d'un ruban déroulable entraîné, qui est destiné à un support mobile (11) sur lequel est fixé le dispositif de coupe transversale (10), dont les deux porte-lame (16,16) sont fixés sur des pièces de guidage (13,13) qui présentent des coussinets à billes (14,14) qui se déplacent sur des axes de guidage (12,12) dans la direction de déplacement (A) de la bande (20), de sorte que les porte-lame munis des lames (18,18) peuvent être mutuellement écartés ou rapprochés, de sorte que, pendant la coupe, les lames s'appliquent respectivement contre le bord arrière et contre le bord avant (29 ou 30) de plaques voisines (4,5) et coupent simultanément transversalement la bande (20), constituée d'une couche de résiste sec, le long de ce bord arrière et de ce bord avant.

2. Dispositif de séparation selon la revendication 1, caractérisé en ce qu'un premier détecteur (23) se trouve dans la région du dispositif de coupe transversale (10), détecteur qui, lorsqu'il détecte le bord avant (30) de chaque plaque (4,5), fournit des signaux à des serre-flans (6,6) pour des barres de pression (7,7), au vérin (2) du dispositif de coupe transversale, et au moteur pour le déplacement longitudinal du dispositif de séparation (1).

3. Dispositif de séparation selon la revendication 1, caractérisé en ce que le support en U (11) pour le dispositif de coupe transversale (10) est fixé comme élément entraîné et guidé sur le vérin d'entraînement (2), qui est un vérin pneumatique dépourvu de tige de piston et doté d'un amortissement, réglable des deux côtés, de son entraînement à ruban.

4. Dispositif de séparation selon la revendication 3, caractérisé en ce que les faces frontales du vérin d'entraînement (2) sont fixées sur des plaques de fixation (9,9), qui sont assemblées au chariot (31) du dispositif de séparation (1) par l'intermédiaire des montants (3) du support de vérin.

5. Dispositif de séparation selon la revendication 2, caractérisé en ce qu'une barre de pression respective (7,7) s'étend sur la largeur de la bande (20) avant et après le dispositif de coupe transversale (10), vu dans le sens de passage (A) de la bande (20).

6. Dispositif de séparation selon la revendication 5, caractérisé en ce que chacune des deux barres de pression (7,7) est assemblée à ses extrémités aux serre-flans (6,6) actionnés pneumatiquement, qui pressent les barres de pression (7,7) contre la bande (20) et cette dernière contre la face de recouvrement du chariot (31), ou les en décollent, et en ce que les serre-flans sont disposés sur les côtés intérieurs de butées angulaires (32,32), qui sont fixées sur le chariot (31) parallèlement aux deux côtés longitudinaux de la bande (20).

7. Dispositif de séparation selon la revendication 1, caractérisé en ce que chaque porte-lame (16) présente deux goupilles (19,19), par lesquelles il peut être emboîté dans des trous (17,17) de la pièce de guidage associée (13), en ce que chaque pièce de guidage (13) est équipée sur les deux côtés de coussinets à billes (14,14), en ce que les axes de guidage (12,12) sont montés dans les branches de U (28,28) du support (11), et en ce que chaque pièce de guidage (13) est reliée en son milieu à un vérin de guidage (15), qui la déplace en va-et-vient le long des axes de guidage (12,12).

8. Dispositif de séparation selon la revendication 7, caractérisé en ce qu'un bras coudé (25), muni d'un second détecteur (24) pour détecter un bord latéral de la plaque (4; 5), est disposé sur une branche de U (28), et en ce que le détecteur (24) fournit des signaux au vérin d'entraînement (2) et aux vérins de guidage (15,15).

9. Dispositif de séparation selon la revendication 1, caractérisé en ce qu'un premier commutateur de fin de course (26) est disposé à proximité de la face terminale avant d'un premier guide à billes (8) et, actionné par la face frontale du chariot (31), déclenche les serre-flans (6,6) qui décollent les barres de pression (7,7) de la face de recouvrement du chariot (31).

10. Dispositif de séparation selon la revendication 1, caractérisé en ce qu'un second commutateur de fin de course (27) se trouve à proximité de la face terminale arrière du premier guide à billes (8) et est actionné par le dispositif de séparation (1) dans sa position initiale, afin d'arrêter le moteur qui déplace en va-et-vient le dispositif, et de débloquer le premier détecteur (23).

Fig. 1

EP 0 220 646 B1

Fig. 2

Fig. 3

Fig. 4

Fig. 5